# EUROPÄISCHE PATENTANMELDUNG

(11) **EP 1 906 533 A1**
(43) Veröffentlichungstag der Anmeldung: **02.04.2008**
(21) Anmeldenummer: 06020510.1
(22) Anmeldetag: 29.09.2006
(51) Int. Cl.: H03K 17/78

(54) **Digitale Eingangsschaltung mit einem opto-elektronischen Bauelement**

(71) Anmelder: SIEMENS AKTIENGESELLSCHAFT, 80333 München (DE)
(72) Erfinder: Glöckner, Knut, 09113 Chemnitz (DE); Klug, Andreas, 08141 Reinsdorf (DE)

(57) **Zusammenfassung**

Digitaleingang wird zur Übertragung von Digitalsignalen aus einem Signalgenerator, insbesondere einem Näherungsschalter (12), ausgebildet. Der Digitaleingang weist zumindest zwei Konstantstromquellen (4,5) und ein opto-elektronisches Verbindungsbauelement (10) zur galvanisch getrennten Signalübertragung auf, wobei eine erste Konstantstromquelle (4) zur Begrenzung des Werts eines Eingangsstroms des Digitaleingangs und eine zweite Konstantstromquelle (5) zur Bereitstellung und/oder Begrenzung eines Ruhestroms des Digitaleingangs vorgesehen sind. Durch den Digitaleingang kann der für den Betrieb des Näherungsschalters (12) notwendige Ruhestrom gewährleistet werden, damit der Digitaleingang für Anschluss mit einem Näherungsschalter (12) kompatibel ist. Außerdem kann durch die Erfindung ein verlustleistungsarmer, kostengünstiger Digitaleingang mit geringem Bauteilaufwand realisiert werden.

## Beschreibung

Die Erfindung betrifft einen Digitaleingang zur Übertragung von Digitalsignalen aus einem Signalgenerator, insbesondere einem Näherungsschalter, mit einem opto-elektronischen Verbindungsbauelement.

Näherungsschalter (BERO: kontakt- und berührungslos arbeitender Sensor) sind Sensoren, die auf Annäherung, also berührungsfrei arbeiten, Wenn man einen Näherungsschalter verwenden möchte, muss man auf den Ruhestrom des Näherungsschalters achten. Bei 2-Leiter-Näherungsschaltern ist die Betriebsspannung diejenige, die der Reihenschaltung von Näherungsschalter und Digitaleingang gemeinsam zur Verfügung steht. Daher fließt ein Ruhestrom in einem Ruhezustand immer über den Digitaleingang, wobei der Näherungsschalter für seinen eigenen Betrieb den Ruhestrom benötigt. Ein üblicher, passiv beschalteter Digitaleingang besitzt eine lineare Kennlinie, die einerseits eine steigende Verlustleistung bei steigender Eingansspannung des Digitaleingangs hat und andererseits nicht den für einen Näherungsschalter benötigten Arbeitsruhestrom liefern kann.

Bei z.B. einer typischen Betriebsspannung von 24V DC weist ein herkömmlicher Digitaleingang einen High-Pegel (logisch hoch) zwischen 15V und 30v und einen Low-Pegel (logisch Tief) zwischen -3V und 5V auf. Bei maximalem High-Pegel von 30V fließt allerdings ein relativ hoher Strom im Digitaleingang, der demzufolge zu einerrelativ hohen Leistungsverlust führt.

Zur Begrenzung der Verlustleistung bei steigender Eingangsspannung ist bereits bekannt, eine preisintensive Konstantstromdiode in der Eingangsschaltung anzuwenden. Alternativ gibt es inzwischen integrierte Lösungen (Digital Termination IC's), die jedoch auch teuer sind und einer zusätzlichen Außenbeschaltung bedürfen.

Wird an einem Digitaleingang ein 2-Draht-Näherungsschalter (2-Leiter-Anschluss) verwendet, soll dem Näherungsschalter ein Ruhestrom durch den Digitaleingang ermöglicht werden, ohne dass der Digitaleingang eingeschaltet wurde.

Im Hinblick auf die oben beschriebenen Schwierigkeiten liegt der Erfindung die Aufgabe zugrunde, einen Digitaleingang zur Übertragung von Digitalsignalen aus einem Signalgenerator, insbesondere einem Näherungsschalter anzugeben und die Verlustleistung des Digitaleingangs zu reduzieren.

Diese Aufgabe wird erfindungsgemäß durch einen Digitaleingang mit den in Patentanspruch 1 angegebenen Merkmalen gelöst. Vorteilhafte Weiterbildungen der Erfindung sind Gegenstand der abhängigen Ansprüche.

Der Erfindung liegt die Idee zugrunde, einen Ruhestrom durch einen Digitaleingang zu ermöglichen, um einen sicheren Betrieb eines an diesem Digitaleingang angeschlossenen Näherungsschalters zu gewährleisten. Ein Digitaleingang ist für übertragung von Digitalsignalen aus einem Signalgenerator, wie z.B. einer SPS (speicherprogrammierbare Steuerung), geeignet, wobei der Digitaleingang ein opto-elektronisches Verbindungsbauelement, z.B. einen Optokoppler, zur galvanisch getrennten Signalübertragung aufweist. Der Ausgang des Digitaleingangs wird dann mittels des opto-elektronischen Verbindungsbauelements ausgebildet. Damit der Digitaleingang BERO-Kompatibel ist, also mit einem berührungslosen Näherungsschalter verbunden werden kann, muss der Digitaleingang zumindest zwei Konstantstromquellen aufweisen. Dabei ist eine erste Konstantstromquelle zur Begrenzung des Werts eines Flussstroms des Digitaleingangs auf einen Stromwert vorgesehen. In der Regel wird der Eingangstrom des opto-elektronischen Verbindungselements dadurch begrenzt. Der Stromwert wird abhängig von der Beschaltung der ersten Konstantstromquelle oder von der Schaltschwelle des opto-elektronischen Verbindungselements vorbestimmt. Durch die Begrenzung des Flussstroms kann die Stromaufnahme im Digitaleingang reduziert werden, damit die Verlustleistung des Digitaleingangs gering gehalten werden kann. Eine zweite Konstantstromquelle ist zur Bereitstellung und/oder Begrenzung eines Ruhestroms durch den Digitaleingang vorgesehen. Der Ruhestrom ist notwendig für den Betrieb des Näherungsschalters. Wenn ein Ruhestrom durch den Digitaleingang fließt, wird das opto-elektronische Verbindungsbauelement bzw. der Digitaleingang nicht eingeschaltet, d.h. am Ausgang des Digitaleingangs bzw. des opto-elektronischen Verbindungselements eine Logik-Low (z.B. 0V) dargestellt wird, weil die Schaltschwelle des opto-elektronischen Verbindungselements nicht überschritten wird.

Die erste und zweite Konstantstromquelle sind zwei herkömmliche Transistor-Konstantstromquellen und sie weisen jeweils einen ersten und zweiten Transistor zur Stromverstärkung auf. Zudem weist die erste Konstantstromquelle einen ersten Widerstand, einen zweiten Widerstand und eine erste Zener-Diode auf, wobei der erste Widerstand zur Begrenzung des Basisstromes des ersten Transistors und zur Begrenzung des Stroms durch die erste zener-Diode vorgesehen ist, wobei der zweite Widerstand zur Bestimmung des Kollektorstroms des ersten Transistors zwischen dem Emitter des ersten Transistors und einem Bezugsspannungsanschluss (in der Regel geerdet mit Potential "Null") angeschlossen ist und wobei die erste Zener-Diode zur Festlegung der Basisspannung des ersten Transistors zwischen der Basis des ersten Transistors und dem Bezugsspannungsanschluss angeschlossen ist,

Gemäß einer vorteilhaften Ausgestaltung der Erfindung weist die zweite Konstantstromquelle neben dem zweiten Transistor einen dritten Widerstand, einen vierten Widerstand und eine zweite Zener-Diode auf. Auf der gleichen Weise wie die erste Konstantstromquelle wird der dritte widerstand zur Begrenzung des Basisstroms des zweiten Transistors und zur Begrenzung des Stroms durch die zweite Zener-Diode zwischen dem Kollektor und der Basis des zweiten Transistors angeschlossen. Der vierte Widerstand wird zur Bestimmung des Kollektorstroms des zweiten Transistors zwischen dem Emitter des zweiten Transistors und dem Bezugsspannungsanschluss angeschlossen und die zweite Zener-Diode wird zur Festlegung der Basisspannung des zweiten Transistors zwischen der Basis des zweiten Transistors und dem Bezugsspannungsanschluss angeschlossen.

Gemäß einer anderen vorteilhaften Ausgestaltung der Erfindung ist ein elektrischer Pfad zwischen einem Eingang des Digitaleingangs und einem ersten Eingang des opto-elektronischen Verbindungsbauelements vorgesehen. Die zweite Konstantstromquelle wird parallel zu der ersten Konstantstromquelle zwischen dem Eingang des Digitaleingangs und der ersten Konstantstromquelle am elektrischen Pfad angeschlossen. Dabei kann der Kollektor des zweiten Transistors zwischen dem Eingang des Digitaleingangs und der ersten Konstantstromquelle am elektrischen Pfad angeschlossen werden.

Gemäß einer weiteren vorteilhaften Ausgestaltung der Erfindung wird der Kollektor des ersten Transistors mit dem zweiten Eingang des opto-elektronischen Verbindungsbauelements verbunden, und der erste widerstand zwischen dem elektrischen Pfad und der Basis des ersten Transistors angeschlossen. Der Digitaleingang kann über das opto-elektronische Verbundenbauelement direkt oder indirekt mit einem anderen Gerät, z.B. Controller, verbunden werden.

Vorteilhafterweise wird ein Kondensator zur Glättung der Eingangsspannung des Digitaleingangs und wegen der EMV-Festigkeit zwischen dem Eingang des Digitaleingangs und den zwei Konstantstromquellen derart am elektrischen Pfad angeschlossen, dass der Kondensator parallel zu den zwei Konstantstromquellen angeordnet ist. Somit kann der Strom durch die erste und zweite Konstantstromquelle nacheinander fließen und stabiler auf einen Stromwert begrenzt werden.

In einer weiteren vorteilhaften Weise wird eine Diode zum Schutz des Digitaleingangs vor einer negativen Spannung im elektrischen Pfad geschaltet. Zudem kann ein mit dem Digitaleingang verbundner Näherungsschalter vor einem zurückzuführenden Strom geschützt werden.

Gemäß einer weiteren vorteilhaften Ausgestaltung der Erfindung wird eine Leuchtdiode (LED) zur Anzeige eines Zustands des Digitaleingangs vorgesehen. Damit ist es ersichtlich und erkennbar, in welchem zustand der Digitaleingang aktuell ist.

Gemäß einer weiteren vorteilhaften Ausgestaltung der Erfindung wird eine dritte Zener-Diode zur Einstellung einer Schaltschwelle des Digitaleingangs auf den elektrischen Pfad geschaltet.

Die Erfindung wird im Folgenden anhand von Zeichnungen näher erläutert. Es zeigen:
- FIG 1:: den schematischen Aufbau eines erfindungsgemäßen Digitaleingangs,
- FIG 2:: eine Darstellung von den U/I-Kennlinien des erfindungsgemäßen Digitaleingangs.

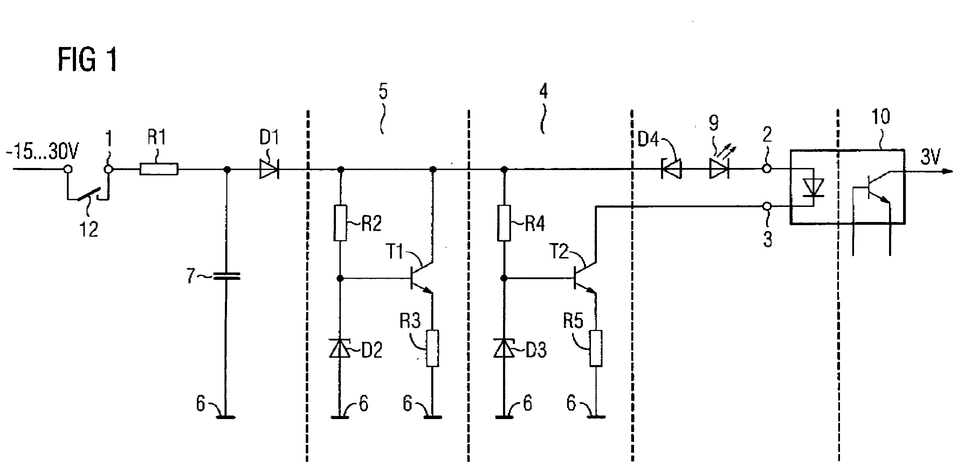

In der Darstellung gemäß FIG 1 ist angezeigt, wie ein BEROkompatibeler Digitaleingang mit einem 2-Draht-Näherungsschalter 12 verbunden und als eine Reihenschaltung geschaltet wird, wobei der Näherungsschalter 12 durch eine Spannung zwischen -15V bis 30V eingespeist wird, Die Betriebsspannung des 2-Draht-Näherungsschalters 12 steht der Reihenschaltung gemeinsam zur Verfügung. Der Näherungsschalter 12 benötigt für seinen eigenen Betrieb den Ruhestrom, wobei der Ruhestrom im Ruhezustand auch immer über den Digitaleingang fließt, auch wenn der Digitaleingang nicht eingeschaltet wurde. Der Digitaleingang weist zwei Konstantstromquellen 4 und 5 und einen Optokoppler 10 zur Signalübertragung mit Potentialtrennung auf, wobei der Optokoppler 10 einen ersten Eingang 2 und einen zweiten Eingang 3 besitzt. Der Digitaleingang ist über den Optokoppler 10 mit einem Controller verbunden. Ein elektrischer Pfad ist zwischen einem Eingang 1 des Digitaleingangs und dem ersten Eingang 2 des Optokopplers 10 ausgebildet.

Die erste Konstantstromquelle 4 und zweite Konstantstromquelle 5 sind zwei herkömmliche Transistor-Konstantstromquellen. Sie besetzen jeweils einen ersten Transistor T2 und einen zweiten Transistor T1 zur Stromverstärkung. Zudem weist die erste Konstantstromquelle 4 einen ersten Widerstand R4, einen zweiten Widerstand R5 und eine erste Zener-Diode D3 auf, und die zweite Konstantstromquelle 5 weist einen dritten Widerstand R2, einen vierten Widerstand R3 und eine zweite Zener-Diode D2 auf. Die zwei Konstantstromquellen werden parallel am elektrischen Pfad angeschlossen. Somit kann der Strom durch die erste und zweite Konstantstromquelle nacheinander fließen und stabiler auf einen Stromwert begrenzt werden. Durch die erste Konstantstromquelle 4 wird der Eingangstrom des Optokopplers 10 auf einem vorbestimmten Stromwert begrenzt, wobei der Wert bspw. auf die Schaltschwelle des Optokopplers 10 abgestellt wird. Durch die zweite Konstantstromquelle 5 wird ein Ruhestrom, der für den Betrieb des Näherungsschalters 12 notwendig ist, bereitgestellt und ebenfalls begrenzt, auch wenn der Digitaleingang nicht eingeschaltet wird, d.h. ein Logik-Low am Ausgang des Digitaleingangs zeigt. Übrigens kann der Ausgangsstrom des Digitaleingangs einen vorbestimmten Stromwert schneller od. mit einer geringeren Ausgangsspannung erreichen.

Dabei wird eine entsprechende Basisspannung des ersten Transistors T2 mit Hilfe der Zener-Diode D3 erzeugt, indem die erste Zener-Diode D3 zwischen der Basis und der Erde (Ground) 6 angeschlossen wird. Der erste Widerstand R4 wird zur Begrenzung des Basisstroms des ersten Transistors T2 und zur Begrenzung des über die erste Zener-Diode D3 fließenden Stroms zwischen dem elektrischen Pfad und der Basis des ersten Transistors T2 angeschlossen. Der zweite Widerstand R5 wird zur Bestimmung des Kollektorstroms des ersten Transistors T2 zwischen dem Emitter und der Erde 6 angeschlossen, und der Kollektor des ersten Transistors T2 wird mit dem zweiten Eingang 3 des Optokopplers 10 verbunden, um den Optokoppler 10 zu betreiben. Dementsprechend wird die zweite Zener-Diode D2 zur Festlegung der Basisspannung des zweiten Transistors T1 zwischen der Basis des zweiten Transistors T2 und der Erde 6 angeschlossen. Der dritte Widerstand R2 wird zur Begrenzung des Basisstroms des zweiten Transistors T1 und zur Begrenzung des durch die zweite Zener-Diode D2 fließenden Stroms zwischen dem Kollektor und der Basis des zweiten Transistors T1 angeschlossen. Der vierte Widerstand R3 wird zur Bestimmung des Kollektorstroms zwischen dem Emitter des zweiten Transistors T1 und der Erde 6 angeschlossen. Der Kollektor des zweiten Transistors T1 wird zwischen dem Eingang 1 und der ersten Konstantstromquelle 4 am elektrischen Pfad angeschlossen. Zudem wird ein fünfter Widerstand R1 zum Schutz des Digitaleingans auf der Seite vom Eingang 1 des Digitaleingangs im elektrischen Pfad geschaltet.

Zur Glättung der Eingangsspannung und zur Erhöhung der EMV-Festigkeit des Digitaleingangs wird ein Kondensator 7 zwischen dem Eingang 1 und den zwei Konstantstromquellen 4 und 5 derart am elektrischen Pfad angeschlossen, dass der Kondensator 7 parallel zu den zwei Konstantstromquellen 4 und 5 angeordnet ist. Eine Diode D1 wird zum Schutz des Digitaleingangs vor einer negativen Spannung im elektrischen Pfad geschaltet. Der am Eingang 1 angeschlossene Näherungsschalter 12 kann ebenfalls durch diese Diode D1 geschützt werden. Eine dritte Zener-Diode D4 wird zur Einstellung der Schaltschwelle des Digitaleingangs auf den elektrischen Pfad geschaltet. Der Zustand des Digitaleingangs sollte außerhalb des Moduls des Digitaleingangs angezeigt werden. Zu diesem Zweck wird eine Leuchtdiode (LED) 9 zur Anzeige eines Zustands des Digitaleingangs neben der dritten Zener-Diode D4 im elektrischen Pfad geschaltet. Dann ist ersichtlich, in welchem Zustand der Digitaleingang aktuell ist.

Durch eine derartige Schaltung kann der für den Betrieb des Näherungsschalters notwendige Ruhestrom gewährleistet werden, damit der Digitaleingang für Anschluss mit einem Näherungsschalter kompatibel ist. Da die Stromaufnahme auf einen bestimmten wert begrenzt wird, stellt der Digitaleingang ebenfalls eine verlustleistungsarme, kostengünstige und mit geringem Bauteilaufwand realisierbare Lösung dar.

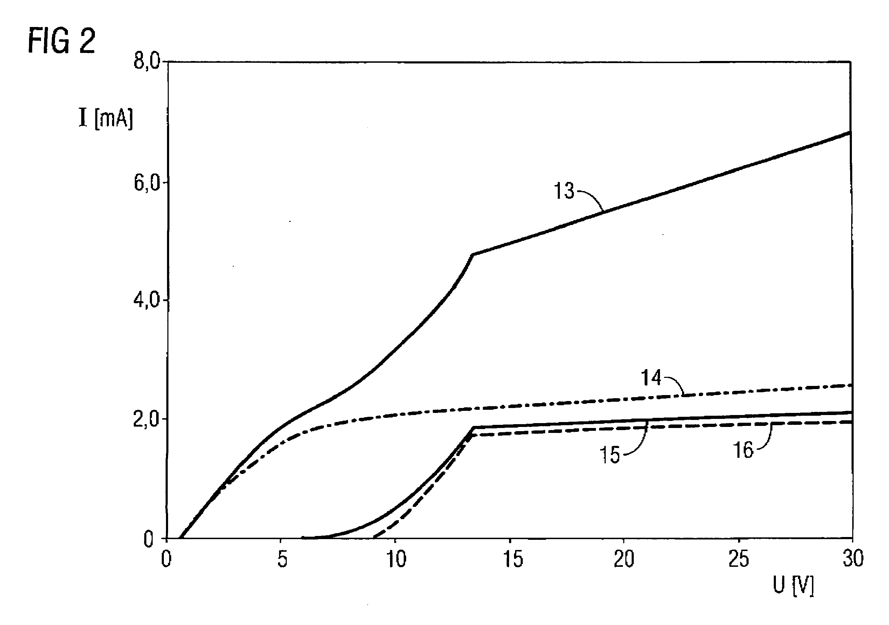

In FIG 2 werden die U/I-Kennlinien für mehrere Bauteile des Digitaleingangs dargestellt. Dabei zeigt die erste Kennlinie 13 für den fünften Widerstand R1, die zweite Kennlinie 14 für den zweiten Transistor T1, die dritte Kennlinie 15 für den ersten Transistor T2, und die vierte Kennlinie 16 für den Optokoppler 10. Durch die Kennlinie 14 wird der Kollektorstrom bzgl. der Kollektor-Emitter-Spannung des zweiten Transistors T1 dargestellt. Durch die Kennlinie 15 wird der Kollektorstrom des ersten Transistors T2, nämlich der Eingangsstrom des Optokopplers 10, im Bezug auf die Kollektor-Emitter-Spannung des ersten Transistors T2, nämlich die Ausgangsspannung des Digitaleingangs dargestellt. Hier ist zu erkennen, dass der Ausgangsstrom des Digitaleingangs oder des Optokopplers 10 durch den Einsatz der ersten Konstantstromquelle 4 auf einem Stromwert von 2mA begrenzt werden kann. Dadurch kann die Stromaufnahme im Digitaleingang reduziert werden, damit die Verlustleistung des Digitaleingangs auch gering gehalten werden kann. Durch den Einsatz der zweiten Konstantstromquelle 5 kann ein Ruhestrom, der notwendig für den Betrieb des Näherungsschalters 12 ist, bereitgestellt und/oder begrenzt werden. Durch die Kennlinien 14 kann man erkennen, dass z.B. bei einer Eingangspannung 5V der Ruhestrom einen Wert von ca. 1,8mA aufweist, wobei der Ruhestrom nicht alleine sondern mit dem Kollektrostrom des zweiten Transistors T1 zusammen durch die Kennlinie 14 dargestellt wird.

## Patentansprüche

1. Digitaleingang zur Übertragung von Digitalsignalen aus einem Signalgenerator, insbesondere einem Näherungsschalter (12), mit einem opto-elektronischen Verbindungsbauelement (10),
wobei das opto-elektronische Verbindungsbauelement (10) zur galvanisch getrennten Signalübertragung vorgesehen ist,
wobei der Digitaleingang zumindest zwei Konstantstromquellen aufweist,
wobei eine erste Konstantstromquelle (4) zur Begrenzung des Werts eines Flussstroms des Digitaleingangs vorgesehen ist, und
wobei eine zweite Konstantstromquelle (5) zur Bereitstellung und/oder Begrenzung eines Ruhestroms des Digitaleingangs vorgesehen ist.

2. Digitaleingang nach Anspruch 1,
**dadurch gekennzeichnet, dass**
die erste Konstantstromquelle (4) einen ersten Transistor (T2), einen ersten Widerstand (R4), einen zweiten Widerstand (R5) und eine erste Zener-Diode (D3) aufweist,
wobei der erste Widerstand (R4) zur Begrenzung des Basisstroms des ersten Transistors (T2) und zur Begrenzung des Stroms durch die erste Zener-Diode (D3) vorgesehen ist,
wobei der zweite Widerstand (R5) zur Bestimmung des Kollektorstroms des ersten Transistors (T2) zwischen dem Emitter des ersten Transistors (T2) und einem Bezugsspannungsanschluss (6) angeschlossen ist, und
wobei die erste Zener-Diode (D3) zur Festlegung der Basisspannung des ersten Transistors (T2) zwischen der Basis des ersten Transistors (T2) und dem Bezugsspannungsanschluss (6) angeschlossen ist.

3. Digitaleingang nach Anspruch 1 oder 2,
**dadurch gekennzeichnet, dass**
die zweite Konstantstromquelle (5) einen zweiten Transistor (T1), einen dritten Widerstand (R2), einen vierten Widerstand (R3) und eine zweite Zener-Diode (D2) aufweist,
wobei der dritte Widerstand (R2) zur Begrenzung des Basisstroms des zweiten Transistors (T1) und zur Begrenzung des Stroms durch die zener-Diode (D2) zwischen dem Kollektor und der Basis des zweiten Transistors (T1) angeschlossen ist,
wobei der vierte Widerstand (R3) zur Bestimmung des Kollektorstroms des zweiten Transistors (T1) zwischen dem Emitter des ersten Transistors (T1) und dem Bezugsspannungsanschluss (6) angeschlossen ist, und
wobei die zweite zener-Diode (D3) zur Festlegung der Basisspannung des zweiten Transistors (T1) zwischen der Basis des zweiten Transistors (T1) und dem Bezugsspannungsanschluss (6) angeschlossen ist.

4. Digitaleingangsschaltung nach einem der Ansprüche 1 bis 3,
**dadurch gekennzeichnet, dass**
ein elektrischer Pfad zur Signalübertragung zwischen einem Eingang (1) des Digitaleingangs und einem ersten Eingang (2) des opto-elektronischen Verbindungsbauelements (10) vorgesehen ist,
wobei die zweite Konstantstromquelle (5) parallel zu der ersten Konstantstromquelle (4) zwischen dem Eingang (1) des Digitaleingangs und der ersten Konstantstromquelle (4) am elektrischen Pfad angeschlossen ist.

5. Digitaleingangsschaltung nach einem der vorherigen Ansprüche,
**dadurch gekennzeichnet, dass**
der Kollektor des ersten Transistors (T2) mit einem zweiten Eingang (3) des opto-elektronischen Verbindungsbauelements (10) verbunden ist, und
der erste Widerstand (R4) zwischen dem elektrischen Pfad und der Basis des ersten Transistors (T2) angeschlossen ist.

6. Digitaleingang nach einem der vorherigen Ansprüche,
**dadurch gekennzeichnet, dass**
ein Kondensator (7) zur Glättung der Eingangsspannung des Digitaleingangs zwischen dem Eingang (1) und den zwei Konstantstromquellen (4,5) derart am elektrischen Pfad angeschlossen ist, dass der Kondensator (7) parallel zu den zwei Konstantstromquellen (4,5) angeordnet ist.

7. Digitaleingang nach einem der vorherigen Ansprüche,
**dadurch gekennzeichnet, dass**
eine Diode (D1) zum Schutz des Digitaleingangs vor einer negativen Spannung im elektrischen Pfad geschaltet ist.

8. Digitaleingang nach einem der vorherigen Ansprüche,
**dadurch gekennzeichnet, dass**
eine Leuchtdiode (9) zur Anzeige eines zustands des Digitaleingangs vorgesehen ist.

9. Digitaleingang nach einem der vorherigen Ansprüche,
**dadurch gekennzeichnet, dass**
eine dritte zener-Diode (D4) zur Einstellung einer Schaltschwelle des Digitaleingangs auf den elektrischen Pfad geschaltet ist.
